**Europäisches Patentamt**

**European Patent Office**

**Office européen des brevets**

(19)

(11) Veröffentlichungsnummer: **0 114 371**
**B1**

(12) # EUROPÄISCHE PATENTSCHRIFT

(45) Veröffentlichungstag der Patentschrift:
08.03.89

(21) Anmeldenummer: 83112934.1

(22) Anmeldetag: 21.12.83

(51) Int. Cl.⁴: **H 01 L 27/08**, H 01 L 29/78

(54) **MISFET mit Eingangsverstärker.**

(30) Priorität: 19.01.83 DE 3301648

(43) Veröffentlichungstag der Anmeldung:
01.08.84 Patentblatt 84/31

(45) Bekanntmachung des Hinweises auf die Patenterteilung:
08.03.89 Patentblatt 89/10

(84) Benannte Vertragsstaaten:
**CH DE FR GB IT LI**

(56) Entgegenhaltungen:
**DE-A-3 114 971**
**US-A-4 199 774**

**ELECTRONIC DESIGN, Band 26, Nr. 4, Februar 1978, Seiten 32-34; D. BARNES: "MOS-controlled triac combines low input power, high output power"**
**ELECTRONIC DESIGN, Band 29, Nr. 12, Juni 1981, Seiten 174-184, Waseca, MN, US; E. HEFTMAN: "MOS and bipolar team up to propel power devices into higher voltage and current altitudes"**
**IEEE INTERNATIONAL ELECTRON DEVICES MEETING, TECHNICAL DIGEST, 5.-7. Dezember 1983, Washington, DC, US; L. LEIPOLD et al.: "Experimental study of a high blocking voltage power MOSFET with integrated input amplifier"**

(73) Patentinhaber: **Siemens Aktiengesellschaft Berlin und München, Wittelsbacherplatz 2, D-8000 München 2 (DE)**

(72) Erfinder: **Tihanyi, Jenö, Dr. Ing., Wolfratshauserstrasse 179b, D-8000 München 71 (DE)**

**Beschreibung**

Die Erfindung bezieht sich auf eine Halbleiteranordnung mit einem Substrat, in dem ein erster Vertikal-MISFET vom ersten Kanaltyp mit einer an der Oberfläche des Substrats liegenden Sourcezone, einer Gatezone und einer Gateelektrode enthalten ist, dessen Drainzone durch das Substrat gebildet ist.

Vertikal-MISFET dieser Art eignen sich für Leistungsanwendungen und sind beispielsweise in der DE-OS-2 703 877 beschrieben worden. Bei einer Direktansteuerung z. B. durch IC's zeigt sich, daß sie wegen ihrer hohen Eingangskapazität nur relativ langsam eingeschaltet werden. Die Schaltgeschwindigkeit könnte durch äußere Treiberschaltungen erhöht werden. Das bedeutet jedoch einen zusätzlichen Aufwand.

Der Erfindung liegt die Aufgabe zugrunde, eine Halbleiteranordnung der obengenannten Gattung derart weiterzubilden, daß die Schaltgeschwindigkeit auch bei geringer Eingangsleistung ohne zusätzlichen Aufwand erhöht wird.

Diese Aufgabe wird gelöst durch die folgenden Merkmale:

a)  Das Substrat enthält einen weiteren Vertikal-MISFET vom ersten Kanaltyp mit einer an der Oberfläche des Substrats liegenden Sourcezone, einer Gatezone und einer Gateelektrode, dessen Drainzone durch das Substrat gebildet ist,

b)  das Substrat enthält einen Lateral-MISFET vom zweiten Kanaltyp mit einer an der Oberfläche des Substrats liegenden Sourcezone und einer an der Oberfläche des Substrats liegenden Drainzone,

c)  die Sourcezonen des weiteren Vertikal-MISFET und des Lateral-MISFET sind elektrisch miteinander und mit der Gateelektrode des ersten Vertikal-MISFET verbunden,

d)  die Gateelektroden des Lateral-MISFET und des weiteren Vertikal-MISFET sind elektrisch miteinander verbunden,

e)  die Drainzone des Lateral-MISFET ist elektrisch mit der Sourcezone des ersten Vertikal-MISFET verbunden.

Weiterbildungen der Erfindung sind Gegenstand der Unteransprüche.

Die Erfindung wird anhand einiger Ausführungsbeispiele in Verbindung mit den Fig. 1 bis 5 näher erläutert. Es zeigen:

Fig. 1          ein Ersatzschaltbild der Halbleiteranordnung gemäß der Erfindung,

Fig. 2          einen Schnitt durch eine prinzipielle Ausführungsform,

Fig. 3          einen Schnitt durch ein Ausführungsbeispiel,

Fig. 4 und 5    die Aufsichten auf zwei Ausführungsbeispiele mit verschiedenen Zuordnungen der Teile der Halbleiteranordnung.

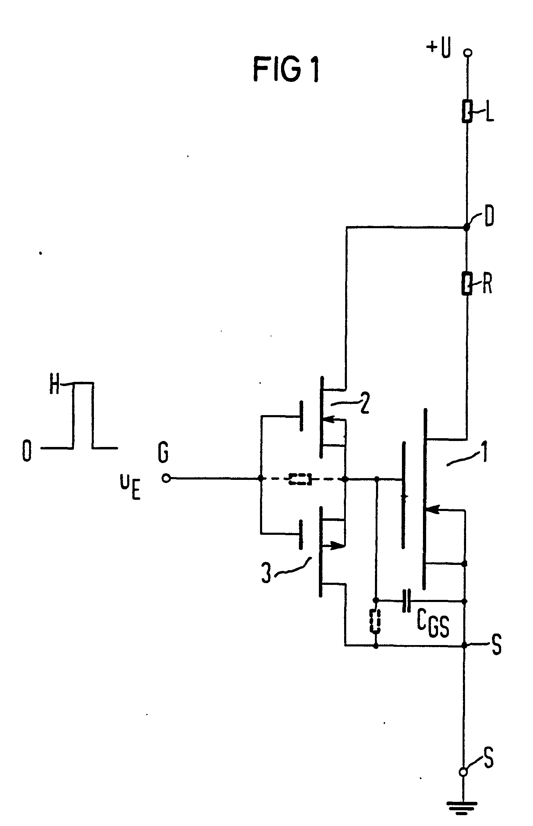

Im Ersatzschaltbild nach Fig. 1 ist der Leistungs-MISFET mit 1 bezeichnet. Er weist drainseitig einen Widerstand R auf, der den Bahnwiderstand des Substrats darstellt. Drainseitig liegt der FET 1 mit der Klemme D über den Widerstand R und eine Last L an einer Spannung +U. Sourceseitig liegt er über die Klemme 5 beispielsweise auf Massepotential. Dem FET 1 und seinem Bahnwiderstand ist die Reihenschaltung bestehend aus einem zweiten MISFET 2 vom gleichen Kanaltyp und einem dritten MISFET 3 vom entgegengesetzten Kanaltyp parallelgeschaltet. Die MISFET 1 und 2 sind als n-Kanal-MISFET dargestellt, während der MISFET 3 vom p-Kanaltyp ist. Die Sourcezonen der MISFET 2 und 3 sind einerseits elektrisch miteinander verbunden und andererseits mit der Gateelektrode des MISFET 1. Die Gateelektroden der MISFET 2 und 3 sind elektrisch miteinander verbunden und bilden einen Gateanschluß G. Die MISFET 2 und 3 bilden einen Vorverstärker für den MISFET 1. Zur Erläuterung der Funktion wurde die Gate-Source-Kapazität $C_{GS}$ des ersten MISFET 1 eingezeichnet.

Wird an den Gateanschluß G eine Signalspannung $u_E$ der gezeigten Form angelegt, so wird der zweite FET 2 leitend gesteuert und an der Gateelektrode des FET 1 erscheint eine positive Spannung. Diese lädt die Kapazität $C_{GS}$ auf und der FET 1 wird eingeschaltet. Wird die Eingangsspannung $u_E$ wieder Null, so bleibt die Gate-Source-Spannung am FET 1, bedingt durch die Ladung in $C_{GS}$, zunächst positiv. Damit wird das Potential der Sourcezone des FET 3 gegenüber seinem Gatepotential positiv und der FET 3 wird leitend. Damit wird die Kapazität $CG_S$ schnell entladen und der FET 1 wird gesperrt.

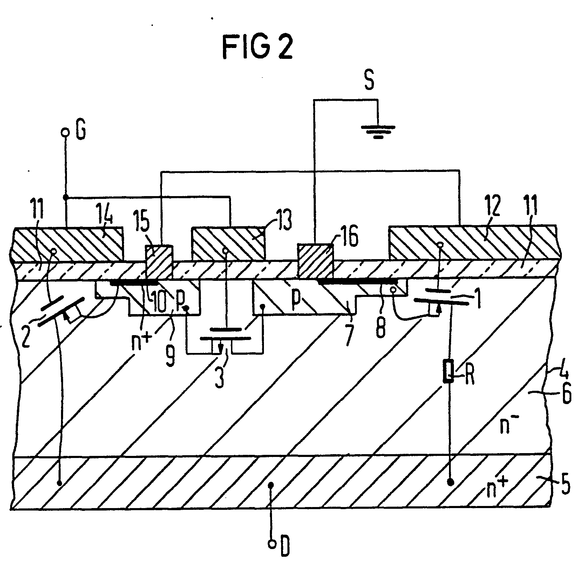

In die Schnittdarstellung nach Fig. 2 sind die Symbole der FET 1, 2 und 3 zur Erläuterung eingezeichnet. Die Halbleiteranordnung ist auf einem Substrat 4 angeordnet, das z. B. aus einer $n^+$-dotierten Zone 5 und einer $n^-$-dotierten Schicht 6 besteht. Letztere kann beispielsweise eine Epitaxieschicht sein. In die Oberfläche der Schicht 6 sind zwei P-leitende Zonen 7 und 9 eingebettet. Die Zonen 7 und 9 bilden die Drainzone bzw. die Sourcezone des FET 3. Dieser ist ein lateraler p-Kanal-FET. In den Zonen 7, 9 sind $n^+$-dotierte Zonen 8 bzw. 10 eingebettet. Diese sind die Sourcezonen für den ersten Vertikal-FET 1 bzw. den zweiten Vertikal-FET 2. Die Zonen 7, 9 bilden auch die Gatezonen für die FET 1 bzw. 2. Diese Anordnung ist besonders platzsparend; die Kanalzonen der FET 1 und 2 könnten jedoch auch von der Source- und Drainzone des FET 3 räumlich getrennt sein. Die Zonen 7, 8 und 9, 10 sind durch je einen Kontakt 16, 15 elektrisch miteinander verbunden. Die Oberfläche des Substrats 4 ist bis auf diejenigen Stellen, wo die Kontakte 15 und 16 sitzen, mit einer Isolierschicht 11, z. B. aus Siliciumdioxid, bedeckt. Auf der Schicht 11 ist eine Gateelektrode 12 angeordnet, die den zwischen Sourcezone 8 und Zone 6 liegenden Teil der Gatezone 7 überdeckt. Die Gateelektrode 12 ist den FET 1 zugeordnet. Zwei weitere Gateelektroden 13, 14 sind den FET 3 bzw. 2 zugeordnet.

Der FET 3 ist ein p-Kanal-Lateral-FET, während FET 2 und FET 1 n-Kanal-Vertikal-FET sind. Die FET 2 und 3 lassen sich gleichzeitig mit dem FET 1 ohne zusätzliche Verfahrensschritte durch die Erzeugung der beiden zusätzlichen Zonen 9 und 10 herstellen. Zur Erzielung eines niedrigen Kanalwiderstands des FET 3 haben die Zonen 7 und 9 einen geringen Abstand von z. B. 10 bis 20 µm. Die Breite seines Kanals soll aus dem gleichen Grund möglichst groß sein.

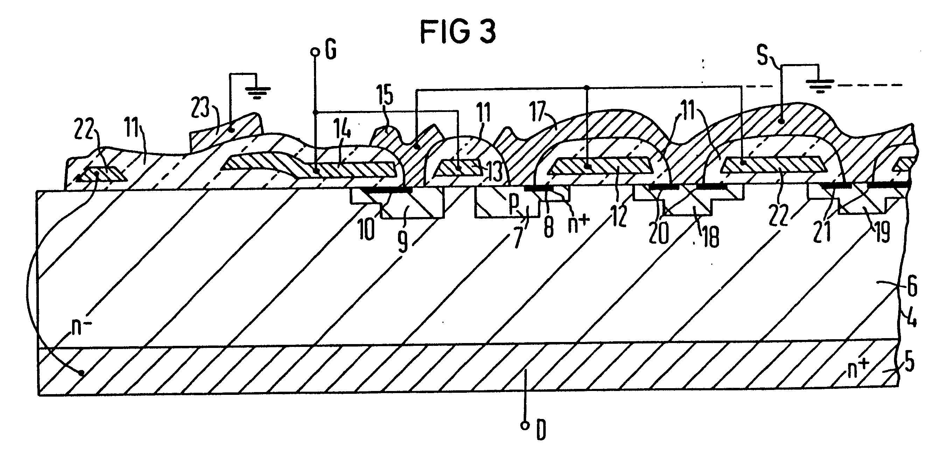

Die den Vorverstärker der Halbleiteranordnung bildenden FET 2 und 3 werden vorzugsweise am Rand des Substrats angeordnet. Eine solche Anordnung ist in Fig. 3 dargestellt. Gleiche Teile wie in Fig. 2 sind hier mit gleichen Bezugszeichen versehen. Das Substrat 4 weist eine Vielzahl von ersten MISFET auf, von denen hier nur einige dargestellt sind. Sie haben Gatezonen 18, 19, in die Sourcezonen 20, 21 eingebettet sind. Diese ersten MISFET sind durch eine Metallschicht 17 einander parallelgeschaltet. Zu jeden der ersten MISFET gehört eine Gateelektrode, von denen hier nur eine weitere dargestellt und mit 22 bezeichnet ist. Die Gateelextrode 22 ist mit eventuellen weiteren Gateelektroden und mit der Gateelektrode 12 elektrisch verbunden. Alle Gateelektroden sind über den Kontakt 15 elektrisch mit den Zonen 9, 10 verbunden.

Die zwischen dem Vertikal-MISFET 2 und dem Rand des Substrats 4 liegende Steuerelektrode 14 kann zum Rand hin einen größeren Abstand zur Oberfläche des Substrats als über der Gatezone 9 aufweisen. Diese Maßnahme dient zusammen mit einem am Rand sitzenden Channel-Stopper 22 und einer die Gateelektrode 14 überlappenden und elektrisch durch die Isolierschicht 11 von ihr getrennten Hilfselektrode 23 einer besseren Verteilung der Randfeldstärke an der Oberfläche des Substrats.

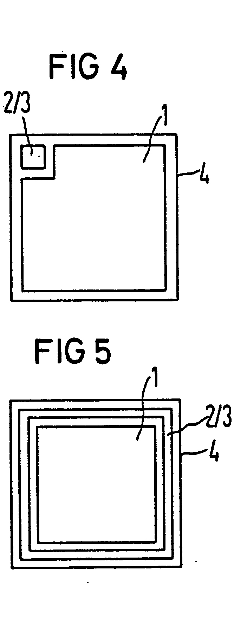

Die MISFET 2, 3 des Eingangsverstärkers können, wie in Fig 3 dargestellt, an Rand des Substrats angeordnet sein. Wie in Fig. 4 gezeigt, können die FET 2, 3 dabei innerhalb einer von den Haupt-FET 1 ausgesparten Fläche des Substrats 4 angeordnet sein. Es ist jedoch auch möglich, die Vorverstärker-FET 2, 3 ringförmig auszubilden und zwischen dem Rand des Substrats 4 und dem TEL 1 anzuordnen. In Fig. 4 und 5 wurde dabei eine stark vereinfachte Darstellung gewählt, die die tatsächliche Feinstruktur der FET 1, 2 und 3 außer Betracht läßt.

Die Erfindung ist z. B. für Hochvolt-MISFET mit einer Sperrspannung z. B. ab 500 V brauchbar.

**Patentansprüche**

1. Halbleiteranordnung mit einem Substrat, in dem ein erster Vertikal-MISFET vom ersten Kanaltyp mit einer an der Oberfläche des Substrats liegenden Sourcezone, einer Gatezone und einer Gateelektrode enthalten ist, dessen Drainzone durch das Substrat gebildet ist, <u>gekennzeichnet</u> durch die Merkmale:

a) Das Substrat (4) enthält einen weiteren Vertikal-MISFET (2) vom ersten Kanaltyp mit einer an der Oberfläche des Substrats liegenden Sourcezone (10), einer Gatezone (9) und einer Gateelektrode (14), dessen Drainzone durch das Substrat (4) gebildet ist,

b) das Substrat enthält einen Lateral-MISFET (3) vom zweiten Kanaltyp mit einer an der Oberfläche des Substrats liegenden Sourcezone (9) und einer an der Oberfläche des Substrats liegenden Drainzone (7),

c) die Sourcezonen (9, 10) des weiteren Vertikal-MISFET (2) und des Lateral-MISFET (3) sind elektrisch miteinander und mit der Gateelektrode (12) des ersten Vertikal-MISFET (1) verbunden,

d) die Gateelektroden (13, 14) des Lateral-MISFET und des weiteren Vertikal-MISFET sind elektrisch miteinander verbunden,

e) die Drainzone (7) des Lateral-MTSFET ist elektrisch mit der Sourcezone (8) des ersten Vertikal-MISFET verbunden.

2. Halbleiteranordnung nach Anspruch 1, <u>dadurch gekennzeichnet</u>, daß einerseits die Gatezone (7) des ersten Vertikal-MISFET (1) und die Drainzone (7) des Lateral-MISFET (3) und andererseits die Sourcezone (9) des Lateral-MISFET (3) und die Gatezone (9) des weiteren Vertikal-MISFET (2) eine einzige zusammenhängende Zone bilden.

3. Halbleiteranordnung nach Anspruch 1 oder 2, <u>dadurch gekennzeichnet</u>, daß in die Drainzone (7) und in die Sourcezone (9) des Lateral-MISFET (3) je eine Zone (8, 10) entgegengesetzten Leitungstyps eingelagert ist, die die Sourcezone des ersten Vertikal-MISFET bzw. die Sourcezone des weiteren Vertikal-MISFET ist.

4. Halbleiteranordnung nach Anspruch 3, <u>dadurch gekennzeichnet</u>, daß einerseits die Sourcezone (8) des ersten Vertikal-MISFET (1) mit der Drainzone (7) des Lateral-MISFET (3) und andererseits die Sourcezone (10) des weiteren Vertikal-MISFET (2) mit der Sourcezone (9) des Lateral-MISFET (3) elektrisch durch je einen Kontakt (15, 16) miteinander verbunden ist.

5. Halbleiteranordnung nach einem der Ansprüche 1 bis 4, <u>dadurch gekennzeichnet</u>, daß das Substrat eine Vielzahl parallelgeschalteter erster Vertikal-MISFET aufweist, daß der weitere Vertikal-MISFET (2) und der Lateral-MISFET (3) ringförmig ausgebildet ist und zwischen dem Rand des Substrats (4) und den dem Rand benachbarten ersten Vertikal-MISFET (1) angeordnet ist.

6. Halbleiteranordnung nach einem der Ansprüche 1 bis 4, <u>dadurch gekennzeichnet</u>, daß

das Substrat (4) eine Vielzahl parallelgeschalteter erster Vertikal-MISFET (1) aufweist und daß der weitere Vertikal-MISFET (2) und der Lateral-MISFET (3) in einer von den ersten Vertikal-MISFET ausgesparten Fläche des Substrats angeordnet sind.

**Claims**

1. Semiconductor arrangement having a substrate which contains a first vertical MISFET of the first channel type which has a source zone situated at the surface of the substrate, a gate zone and a gate electrode, and whose drain zone is formed by the substrate, characterized by the features:
   a) The substrate (4) contains a further vertical MISFET (2) of the first channel type which has a source zone (10) situated at the surface of the substrate, a gate zone (9) and a gate electrode (14), and whose drain zone is formed by the substrate (4),
   b) The substrate contains a lateral MISFET (3) of the second channel type which has a source zone (9), situated at the surface of the substrate, and a drain zone (7), situated at the surface of the substrate,
   c) The source zones (9, 10) of the further vertical MISFET (2) and of the lateral MISFET (3) are electrically connected to each other and to the gate electrode (12) of the first vertical MISFET (1),
   d) The gate electrodes (13, 14) of the lateral MISFET and of the further vertical MISFET are electrically connected to each other,
   e) The drain zone (7) of the lateral MISFET is electrically connected to the source zone (8) of the first vertical MISFET.

2. Semiconductor arrangement according to Claim 1, characterized in that, on the one hand, the gate zone (7) of the first vertical MISFET (1) and the drain zone (7) of the lateral MISFET (3) and, on the other hand, the source zone (9) of the lateral MISFET (3) and the gate zone (9) of the further vertical MISFET (2) form a single continuous zone.

3. Semiconductor arrangement according to Claim 1 or 2, characterized in that the drain zone (7) and the source zone (9) of the lateral MISFET (3) each incorporate a zone (8, 10) of the opposite conduction type which is the source zone of the first vertical MISFET or, respectively, the source zone of the further vertical MISFET.

4. Semiconductor arrangement according to Claim 3, characterized in that, on the one hand, the source zone (8) of the first vertical MISFET (1) and the drain zone (7) of the lateral MISFET (3) and, on the other hand, the source zone (10) of the further vertical MISFET (2) and the source zone (9) of the lateral MISFET (3) are electrically connected to each other by one contact (15, 16) in each case.

5. Semiconductor arrangement according to one of Claims 1 to 4, characterized in that the substrate contains a multiplicity of first vertical MISFETs connected in parallel and in that the further vertical MISFET (2) and the lateral MISFET (3) is of annular construction and is arranged between the edge of the substrate (4) and the edge of the adjacent first vertical MOSFET (sic) (1) adjacent to the edge.

6. Semiconductor arrangement according to one of Claims 1 to 4, characterized in that the substrate (4) contains a multiplicity of first vertical MISFETs (1) connected in parallel and that the further vertical MISFET (2) and the lateral MISFET (3) are arranged in an area of the substrate untouched by the first vertical MISFET.

**Revendications**

1. Dispositif à semi-conducteurs, avec un substrat, dans lequel est contenu un premier MISFET vertical d'un premier type de canal, avec une zone de source qui se situe sur la surface du substrat, avec une zone de grille, et avec une électrode de grille, dont la zone de drain est formée par le substrat, caractérisé par les particularités suivantes:
   a) le substrat (4) comporte un second MISFET vertical (2) du premier type de canal, avec une zone de source (10) qui se situe à la surface du substrat, avec une zone de grille (9) et avec une électrode de grille (14), et dont la zone de drain est formée par le substrat (4),
   b) le substrat comporte un MISFET latéral (3) d'un seconde type de canal, avec une zone de source (9) qui se situe sur la surface du substrat, et avec une zone de drain (7) qui se situe sur la surface du substrat,
   c) les zones de source (9, 10) du second MISFET vertical (2) et du MISFET latéral (3) sont reliées électriquement entre elles et avec l'électrode de grille (12) du premier MISFET vertical (1),
   d) les électrodes de grille (13, 14) du MISFET latéral et du seconde MISFET vertical sont reliées entre elles électriquement,
   e) la zone de drain (7) du MISFET latéral est reliée électriquement avec la zone de source (8) du premier MISFET vertical.

2. Dispositif à semi-conducteurs selon la revendication 1, caractérisé par le fait que d'une part la zone de grille (7) du premier MISFET vertical (1) et la zone de drain (7) du MISFET latéral (3), et, d'autre part, la zone de source (9) du MISFET latéral (3) et la zone de grille (9) du second MISFET vertical (2), forment une zone unique et d'un seul tenant.

3. Dispositif à semi-conducteurs selon la revendication 1 ou 2, caractérisé par le fait que respectivement dans la zone de drain (7) et dans la zone de source (9) du MISFET latéral (3) est insérée une zone (8, 10) du type de conductivité opposé, et qui forme la zone de source du premier MISFET vertical, respectivement la zone de source du second MISFET vertical.

4. Dispositif à semi-conducteurs selon la revendication 3, caractérisé par le fait que d'une part, la zone de source (8) du premier MISFET vertical (1) est reliée électriquement à la zone de drain (7) du MISFET latéral (3), et, d'autre part, la zone de source (10) du second MISFET vertical (2) est reliée électriquement à la zone de source (9) du MISFET latéral (3), la liaison se faisant respectivement par un contact (15, 16).

5. Dispositif à semi-conducteurs selon l'une des revendications 1 à 4, caractérisé par le fait que le substrat comporte une pluralité de premiers MISFET vertical, montés en parallèle, que le second MISFET vertical (2) et le MISFET latéral (3) sont réalisés sous forme annulaire et sont disposés entre le bord du substrat (4) et le premier MISFET vertical (1) qui est voisin du bord.

6. Dispositif à semi-conducteurs selon l'une des revendications 1 à 4, caractérisé par le fait que le substrat (4) comporte une pluralité de premiers MISFET verticaux (1), montés en parallèle, et que le second MISFET vertical (2) et le MISFET latéral (3) sont disposés dans une surface du substrat qui a été évidé lors de la réalisation du premier MISFET vertical.

# FIG 1

# FIG 2

# FIG 3

EP 0 114 371 B1

## FIG 4

## FIG 5